# EUROPÄISCHE PATENTANMELDUNG

(11) **EP 4 462 593 A1**
(43) Veröffentlichungstag der Anmeldung: **13.11.2024**
(21) Anmeldenummer: 24170307.3
(22) Anmeldetag: 15.04.2024
(51) Int. Cl.: H01Q 1/22, H01Q 1/52, H01Q 21/00, H01P 5/02, H01P 5/107

(54) **MODULARE ANTENNENANORDNUNG**

(30) Priorität: 08.05.2023 DE 102023111906
(71) Anmelder: Sykno GmbH, 91058 Erlangen (DE)
(72) Erfinder: SCHEINER, Benedict, 91054 Erlangen (DE); MICHLER, Fabian, 91054 Erlangen (DE); REIßLAND, Torsten, 91058 Erlangen (DE); LOMAKIN, Konstantin, 91058 Erlangen (DE); HOFMANN, Andreas, 91054 Erlangen (DE); SIPPEL, Mark, 90766 Fürth (DE)
(74) Vertreter: Herrmann, Uwe

(57) **Zusammenfassung**

Die vorliegende Erfindung betrifft eine modulare Antennenanordnung (1), insbesondere modulare MIMO-Antennenanordnung, zum Evaluieren unterschiedlicher Antennenanordnungscharakteristika, und umfasst eine Leiterplatte (2) mit einem Chipsatz (3), um eine hochfrequente elektromagnetische Welle zu senden und/oder zu empfangen, sowie mindestens eine Entflechtungskomponente (4) zum Aufsetzen auf die Leiterplatte (2), um die von der Leiterplatte (2) abgehende elektromagnetische Welle zu einem Übergabepunkt (5) der Entflechtungskomponente (4) und/oder die an einem Übergabepunkt (5) der Entflechtungskomponente (4) empfangene elektromagnetische Welle zu der Leiterplatte (2) zu leiten.

## Beschreibung

Die vorliegende Erfindung betrifft eine modulare Antennenanordnung, insbesondere eine modulare MIMO-Antennenanordnung.

MIMO steht dabei für Multiple Input - Multiple Output und bezeichnet ein Prinzip in der Funktechnik, bei dem mehrere Sende- und Empfangselemente genutzt werden, um einen Mehrgewinn an Informationen zu erzielen. In einem Radarsystem können dadurch unter anderem Winkelauflösungen erzielt werden, die allerdings abhängig vom Typ und der Anordnung der verwendeten Einzelstrahler sind.

Antennen und damit erzeugbare Radare haben in den letzten Jahren immer weiter Verbreitung gefunden, wobei insbesondere der Wunsch, in der Zukunft Fahrzeuge autonom fahren zu lassen, ein treibender Faktor hierfür ist. Von vielen Fachleuten wird es dabei als unerlässlich angesehen, dass Fahrzeuge ihre Umgebung mithilfe von Radaren abtasten, um eine möglichst fehlerfreie Erfassung der Umgebung zu gewährleisten und die Möglichkeit zu schaffen, eine kollisionsfreie Route zu wählen.

Aber nicht nur die Ortung von Gegenständen, sondern auch die Kommunikation von Daten wird mithilfe von Antennenanordnungen durchgeführt, bei denen eine spezifische Antennencharakteristik von Vorteil sein kann.

Um während der Entwicklungsphase einer Antennenanordnung eine für die zugrunde liegende Aufgabe möglichst optimale Antennenkonfiguration zu erreichen, bieten Hersteller von Ortungs- oder Kommunikations-Chipsätzen sogenannte Evaluierungsplattformen mit mehreren unterschiedlichen vorgegebenen Antennenkonfigurationen an, welche die Abstrahl- bzw. Empfangscharakteristik des Gesamtsystems jeweils fest vorgeben.

Davon abweichende Antennenkonfigurationen erfordern die Entwicklung anwendungsspezifischer Systeme. Typische Evaluierungsplattformen bestehen aus einer Kombination mehrerer Leiterplatten, die ineinandergesteckt werden müssen, beispielsweise einer Basisband-/Versorgungsplatine und einer Hochfrequenzplatine. Um die Abstrahlcharakteristik anzupassen, muss daher nicht das gesamte System, sondern lediglich die Hochfrequenzplatine mit den darauf befindlichen Antennen ausgetauscht werden. Dadurch kann zwar die Basisband-/Versorgungsplatine wiederverwendet werden, dennoch müssen die Komponenten der Hochfrequenzplatine neu entworfen, angeschafft und verlötet werden, was einen hohen Kosten- und Zeitaufwand erfordert. Die Evaluierung unterschiedlicher Antennencharakteristika durch das Verwenden unterschiedlicher Konfigurationen von Antennenanordnungen ist daher in ihrer Umsetzung äußerst aufwendig und kostenintensiv.

Eine solche aus dem Stand der Technik bekannte Umsetzung wird bspw. von der Firma Infineon unter dem Namen "BGT60ATR24C shield" vermarktet, wobei hier auf eine Basisbandplatine die Hochfrequenzplatine "BGT60ATR24C shield" mit darauf angeordneten Antennenaufgesteckt werden kann, sodass man eine weitere Antennenanordnung mit einem anderen IC erhält.

Es ist das Ziel der vorliegenden Erfindung eine modulare Antennenanordnung zu schaffen, die die oben aufgeführten Nachteile zumindest teilweise überwindet. Dies gelingt mit einer modularen Antennenanordnung, die sämtliche Merkmale des Anspruchs 1 aufweist.

Nach der Erfindung ist eine modulare Antennenanordnung, insbesondere modulare MIMO-Antennenanordnung, zum Evaluieren unterschiedlicher Antennenanordnungscharakteristika, vorgesehen, die eine Leiterplatte mit einem Chipsatz, um eine hochfrequente elektromagnetische Welle zu senden und/oder zu empfangen, und mindestens eine Entflechtungskomponente zum Aufsetzen auf die Leiterplatte umfasst, um die von der Leiterplatte abgehende elektromagnetische Welle zu einem Übergabepunkt der Entflechtungskomponente und/oder die an einem Übergabepunkt der Entflechtungskomponente empfangene elektromagnetische Welle zu der Leiterplatte zu leiten. Sind mehrere Entflechtungskomponenten vorhanden, kann z.B mindestens eine für Tx und mindestens eine für Rx vorgesehen sein, also mindestens eine für das Senden und mindestens eine für das Empfangen.

Der Übergabepunkt der Entflechtungskomponente kann dabei so ausgestaltet sein, dass auch ein Abstrahlen oder ein Empfangen einer elektromagnetischen Welle erfolgen kann. Ebenfalls kann aber vorgesehen sein, dass der Übergabepunkt der Entflechtungskomponente die elektromagnetische Welle an eine weitere mit der Entflechtungskomponente zusammenwirkende Komponente abgibt bzw. eine elektromagnetische Welle von der weiteren Komponente aufnimmt.

Grundsätzlich ermöglicht die erfindungsgemäße Anordnung modulare Kommunikations- und Radarsysteme mit wechselbaren Antennenpositionen und -typen. Als Basis dient dabei immer dieselbe Leiterplatte, da dort bereits ein Chipsatz vorgesehen ist, um eine hochfrequente elektromagnetische Welle zu senden und/oder zu empfangen. Anders als nach dem Stand der Technik ist es demnach nicht mehr notwendig, weitere Logikbausteine zum Erzeugen einer hochfrequenten elektromagnetischen Welle in dem auf die Leiterplatte aufzusetzenden weiteren Element vorzusehen, sodass auch das Vorsehen von elektrischen Verbindungen zwischen den beiden miteinander zusammenwirkenden Komponenten nicht mehr erforderlich ist.

Nach der Erfindung ist vorgesehen, dass die Leiterplatte bereits sämtliche für das Abstrahlen bzw. das Empfangen einer hochfrequenten elektromagnetischen Welle erforderlichen Bauteile besitzt, sodass die mit der Leiterplatte zusammenwirkende Entflechtungskomponente nur noch dazu dient, die finale Abstrahlposition der mindestens einen elektromagnetischen Welle zu definieren.

Hierzu weist die Entflechtungskomponente mindestens einen Leiter für die von der Leiterplatte erzeugte bzw. zu empfangende mindestens eine elektromagnetische Welle auf, um eine jeweilige elektromagnetische Welle an einen vorbestimmten Abstrahlort (Übergabepunkt) der Entflechtungskomponente zu leiten bzw. von einem vorbestimmten Empfangsort (Übergabepunkt) der Entflechtungskomponente an die Leiterplatte zu leiten.

Das Evaluieren von unterschiedlichen Antennentypen oder Antennencharakteristika beschränkt sich nach der vorliegenden Erfindung auf das Aufsetzen verschieden ausgebildeter Entflechtungskomponenten, die für sich genommen jeweils eine bestimmte Antennenkonfiguration aufweisen und über keinen Chipsatz oder Logikbaustein verfügt. Eine Entflechtungskomponente weist dabei lediglich mindestens einen Leiter für eine elektromagnetische Welle auf, bspw. einen Hohlleiter oder einen dielektrischen Wellenleiter.

Nach einer vorteilhaften Modifikation der vorliegenden Erfindung kann vorgesehen sein, dass die modulare Antennenanordnung ferner eine Sende-Empfangskomponente zum Aufsetzen auf die Entflechtungskomponente umfasst, um eine von der Leiterplatte stammende elektromagnetische Welle von dem Übergabepunkt der Entflechtungskomponente aufzunehmen und über mindestens eine Antenne abzustrahlen oder über ein Koppelelement zurückzukoppeln, und/oder um eine von der Sende-Empfangskomponente mittels mindestens einer Antenne empfangene oder mittels mindestens einem Koppelelement zurückgekoppelte elektromagnetische Welle an den Übergabepunkt der Entflechtungskomponente zum Weiterleiten an die Leiterplatte zu übergeben.

Demnach kann nach der vorliegenden Erfindung vorgesehen sein, dass die modulare Antennenanordnung neben der Leiterplatte und der Entflechtungskomponente eine Sende-Empfangskomponente aufweist, die auf die Entflechtungskomponente aufzusetzen ist. Die Leiterplatte mit ihrem Chipsatz übernimmt dabei die vollständige Verarbeitung einer empfangenen bzw. zu sendenden elektromagnetischen Welle und strahlt diese im finalen, hochfrequenten Wellenbereich ab bzw. nimmt die empfangene hochfrequente Welle auf. Die aufgesetzte Entflechtungskomponente nimmt mit ihren mindestens einem Leiter die von der Leiterplatte abgestrahlte elektromagnetische mindestens eine Welle auf und leitet diese an mindestens einen vorbestimmten Übergabepunkt weiter. Auf die Entflechtungskomponente wiederum wird eine Sende-Empfangskomponente aufgesetzt, die die elektromagnetische Welle von dem mindestens einem Übergabepunkt der Entflechtungskomponente aufnimmt und diese bspw. über eine spezifische Antennenkonfiguration abstrahlt. Die Sende-Empfangskomponente kann dabei aber auch mindestens ein Koppelelement aufweisen, um einen ersten Übergabepunkt mit einem zweiten Übergabepunkt der Entflechtungskomponente leitungstechnisch zu verbinden.

Durch das Vorsehen der Entflechtungskomponente ist es also möglich, unterschiedliche Sende-Empfangskomponenten zu evaluieren, wobei für eine spezifische Leiterplatte lediglich eine jeweilige Entflechtungskomponente vorzusehen ist, die dazu ausgelegt ist, die von der Leiterplatte abgestrahlten elektromagnetischen Wellen auf vordefinierte Übergabepunkt zu leiten. Man kann somit unterschiedlichste Sende-Empfangskomponenten vorhalten und muss zum Evaluieren mit einer entsprechenden Leiterplatte (die eine spezifischen Chipsatz enthält) lediglich eine auf die Leiterplatte abgestimmte Entflechtungskomponente erzeugen. Diese verbindet demnach die unterschiedlichen Sende-Empfangskomponenten mit der Leiterplatte. Aber auch das Evaluieren neuer (dreidimensionaler) Antennentypen ist dadurch bedeutend einfacher.

Eine Entflechtungskomponente beschreibt dabei Leitungsstrukturen, welche die hochfrequente Verbindung zwischen Leiterplatte und abstrahlenden Antennenelementen (welche auf der Entflechtungskomponente selbst oder auf einem auf der Entflechtungskomponente anbringbaren Sende-Empfangselement angeordnet sein können) herstellen. Diese Verbindung stellt üblicherweise eine räumliche Expansion von eng aneinander liegenden Leiterbahnen zu in der Ebene oder dreidimensional verteilt angeordneten Antennenelementen oder Gruppenantennen (eine Antenne, die aus der mehreren Einzelstrahlern besteht, die entweder im Analogen oder im Digitalen kombiniert werden.) dar. Das Entflechtungsnetzwerk ist typischerweise eine dreidimensionale Struktur. Die Leitungslängen im Entflechtungsnetzwerk weisen sinnvollerweise definierte Längen auf.

Die beschriebene Anordnung ermöglicht zudem die Charakterisierung von 3D-gedruckten Antennen, in dem diese nach der Fertigung auf die auf der Leiterplatte befindliche Entflechtungskomponente, in Form entsprechend ausgebildeter Sende-Empfangskomponenten 6, aufgesetzt werden und bezüglich ihres Abstrahlverhaltens vermessen werden. Da kein Netzwerkanalysator benötigt wird und keine Schrauben erforderlich sind, kann durch dieses Verfahren eine hohe Anzahl an Antennen getestet werden.

Nach einer optionalen Modifikation der vorliegenden Erfindung ist vorgesehen, dass eine jede Länge von mehreren Leitern der Entflechtungskomponente gleich ist, sich um ein Vielfaches der vollständigen, der halben und/oder eines Viertels der Wellenlänge des durch die die Leiterplatte erzeugbaren hochfrequenten elektromagnetischen Welle unterscheidet. Selbiges gilt für die Gesamtlänge von Leitungsweg von Entflechtungskomponente und Sende-Empfangskomponente.

Ferner kann nach der vorliegenden Erfindung vorgesehen sein, dass die Leiterplatte und die Entflechtungskomponente in einem aufgesetzten Zustand über ein Ausrichtungsmittel verfügen, das eine vorgegebene Positionierung der Entflechtungskomponente zu der Leiterplatte definiert, vorzugsweise wobei das Ausrichtungsmittel mindestens eine Durchgangsbohrung in der Entflechtungskomponente und der Leiterplatte ist, die in einem aufgesetzten Zustand zueinander fluchten und durch welche ein Passstift einfügbar ist.

Durch das Ausrichtungsmittel wird sichergestellt, dass die beiden zusammenwirkenden Komponenten so zusammengefügt werden, dass die von der Leiterplatte erzeugte mindestens eine elektromagnetische Welle in einen jeweiligen Leiter der Entflechtungskomponente mit möglichst geringer Dämpfung übergeben wird.

Nach einer weiteren vorteilhaften Fortbildung der vorliegenden Erfindung kann vorgesehen sein, dass die Entflechtungskomponente in einem aufgesetzten Zustand auf der Leiterplatte zusammen mit der Leiterplatte und/oder der Sende-Empfangskomponente über ein Ausrichtungsmittel verfügt, das eine vorgegebene Positionierung der Sende-Empfangskomponente zu der Entflechtungskomponente definiert, vorzugsweise wobei das Ausrichtungsmittel mindestens eine Durchgangsbohrung in der Entflechtungskomponente und der Sende-Empfangskomponente ist, die zueinander fluchten und durch welche ein Passstift einfügbar ist, bevorzugterweise derart, dass die Durchgangsbohrung mit einer Durchgangsbohrung in der Leiterplatte fluchtet.

Selbstverständlich ist auch für die Ausrichtung der Sende-Empfangskomponente gegenüber der Entflechtungskomponente ein Ausrichtungsmittel von Vorteil, wobei bei einer Anordnung von Leiterplatte, Entflechtungskomponente und Sende-Empfangskomponente eine jeweilige Bohrung in jeder der Komponenten bzw. ein entsprechender Passstift in einer solchen Bohrung, auf einfache Art und Weise die korrekte Ausrichtung der mehreren Komponenten sicherstellt. Dem Fachmann ist klar, dass es zur korrekten Ausrichtung der verschiedenen Komponenten mehrere mögliche Umsetzungen von Ausrichtungsmitteln gibt, wobei vorliegend nur beispielhaft die fluchtende Anordnung mehrerer Durchgangsbohrungen der einzelnen Komponenten dargestellt worden ist, in die bspw. ein Passstift zur Fixierung der Komponenten einsteckbar ist.

Vorzugsweise kann nach der Erfindung vorgesehen sein, dass mindestens eine Leiterplattenantenne zum Senden und/oder Empfangen in einem Gehäuse des Chipsatzes angeordnet ist, vorzugsweise als in den Chipsatz integrierte Chipsatzantenne in Form eines Wellenleiterübergangs.

Nach der Erfindung ist also möglich, dass der auf der Leiterplatte angeordnete Chipsatz über mindestens eine integrierte Antenne zum Abgeben einer hochfrequenten elektromagnetischen Welle verfügt. Dabei kann vorgesehen sein, dass zum Einleiten der hochfrequenten elektromagnetischen Welle in die Entflechtungskomponente der leiterplattenseitige Eingang des Leiters der Entflechtungskomponente direkt auf den Chipsatz gerichtet ist.

Vorzugsweise kann nach der Erfindung ebenfalls vorgesehen sein, dass mindestens eine Leiterplattenantenne zum Senden und/oder Empfangen neben einem Gehäuse des Chipsatzes in der Leiterplatte angeordnet ist, vorzugsweise als Platinenschnittstelle in Form eines Wellenleiterübergangs.

Nach einer solchen Umsetzung verfügt die Leiterplatte über eine Verbindung hin zum Chipsatz, wobei an einem von der Leiterplatte distalen Bereich der Verbindung mindestens eine Antenne zum Abgeben einer hochfrequenten elektromagnetischen Welle vorgesehen ist.

Eine mit der Leiterplatte zusammenwirkende Entflechtungskomponente weist demnach einen leiterplattenseitigen Eingang des Leiters auf, der direkt auf die Leiterplatte und nicht auf den dort befindlichen Chipsatz gerichtet ist.

Nach einer vorteilhaften Modifikation der vorliegenden Erfindung kann vorgesehen sein, dass der Chipsatz dazu ausgelegt ist, eine Verarbeitung einer zu empfangenden und/oder einer zu sendenden elektromagnetischen Welle im Hochfrequenzbereich und im Basisbandbereich auszuführen.

Ferner kann vorgesehen sein, dass der Chipsatz mindestens ein Radar- bzw. Kommunikationschipsatz ist, und/oder wobei eine Versorgungselektronik zum Betreiben des Chipsatzes auf der Leiterplatte angeordnet ist.

Nach der Erfindung kann demnach vorgesehen sein, dass die Leiterplatte mit ihrem darauf befindlichen Chipsatz keine weiteren Logikbausteine benötigt, um eine hochfrequente elektromagnetische Welle zu erzeugen bzw. deren Empfang zu verarbeiten.

Nach einer weiteren vorteilhaften Fortbildung der vorliegenden Erfindung kann vorgesehen sein, dass die Entflechtungskomponente und/oder die Sende-Empfangskomponente mit Hilfe eines 3D-Druckverfahrens, eines Spritzgussverfahrens, eines Druckgussverfahrens und/oder eines Fräsverfahrens gefertigt ist/sind, wobei vorzugsweise ein Kunststoff das Grundmaterial für das Herstellverfahren bildet.

Insbesondere die Verwendung eines Kunststoffs als Grundmaterial für das Herstellverfahren ermöglicht die rasche Erzeugung einer Entflechtungskomponente bzw. einer Sende-Empfangskomponente, da mit Kunststoff arbeitende 3-D Druckverfahren eine hohe Marktverfügbarkeit aufweisen und sich bereits bewährt haben. Um nun bspw. einen Hohlleiter einer Entflechtungskomponente, die mit einem 3-D Druckverfahren erzeugt worden ist, zu erzeugen, bietet es sich an, das zunächst mit Kunststoff gedruckte Element zu metallisieren. Dadurch wird die Leitfähigkeit für elektromagnetische Wellen geschaffen, sodass das Verfahren gegenüber einem Fräsverfahren von vollständig aus Metall bestehenden Blöcken deutlich schneller und billiger ist.

Durch Fertigungsverfahren wie den metallisierten 3D-Druck von hohlleiterbasierten Wellenleitern, die für sehr hohe Betriebsfrequenzen ausgelegt sind und nur minimale Verluste verursachen, ist es möglich, dasselbe System mit unterschiedlichen Antennentypen und Anordnungen miteinander zu vergleichen. Diese Herstellungsverfahren zeichnen sich zudem durch schnelle Prototypenfertigung aus.

Nach der Erfindung kann also vorgesehen sein, dass die Entflechtungskomponente und/oder die Sende-Empfangskomponente metallisierte Bestandteile aufweist oder metallisiert ist.

Bei einer Metallisierung wird typischerweise auf einen nicht metallenen Grundkörper eine Metallschicht aufgebracht, um die vorteilhaften Eigenschaften einer metallenen Oberfläche zu erhalten. Da die Metallisierung in der Regel mittels nasschemischer Verfahren durchgeführt wird, ist auch das Vorhandensein von komplexen Strukturen, bspw. bei gewinkelten Hohlleitern im Inneren einer Entflechtungskomponente unproblematisch.

Nach einer vorteilhaften Fortbildung der vorliegenden Erfindung kann vorgesehen sein, dass die Sende-Empfangskomponente dazu ausgelegt ist, eine von der Leiterplatte stammende elektromagnetische Welle von der Entflechtungskomponente aufzunehmen und an diese zurückzukoppeln, vorzugsweise durch das Verbinden von mehreren Übergabepunkten der Entflechtungskomponente mit einem Wellenleiter.

Ferner kann nach der vorliegenden Erfindung vorgesehen sein, dass die Sende-Empfangskomponente dazu ausgelegt ist, eine von der Leiterplatte stammende elektromagnetische Welle von der Entflechtungskomponente aufzunehmen und über eine Antennenapertur abzustrahlen, vorzugsweise wobei die Sende-Empfangskomponente eine Vielzahl von Antennenaperturen aufweist, die nicht in einer gemeinsamen Ebene angeordnet sind, um eine 3D-Antenne zu bilden.

Bei den bisher verfügbaren Evaluationsplattformen aus dem Stand der Technik sind die Antennen in der Regel als planare Elemente in die Leiterplatte integriert. Dadurch können diese nicht ausgetauscht bzw. in ihrer Position variiert werden. Eine Änderung der Antennentypen und/oder -positionen erfordert somit ein neues Design und die Fertigung und Bestückung der gesamten Leiterplatte, wodurch hohe Kosten und ein großer Zeitaufwand entstehen.

Vorzugsweise kann nach der Erfindung vorgesehen sein, dass die Entflechtungskomponente zum Leiten der elektromagnetischen Welle mindestens einen Hohlleiter aufweist, wobei die Entflechtungskomponente zum Leiten mehrerer von der Leiterplatte stammender elektromagnetischer Wellen vorzugsweise mehrere Hohlleiter aufweist, deren Leitungskanäle in der Entflechtungskomponente nicht miteinander verbunden sind.

Nach der Erfindung kann vorgesehen sein, dass für jede von der Leiterplatte abgestrahlte elektromagnetische Welle ein eigener Leiter, insbesondere Hohlleiter, vorgesehen ist.

Nach einer optionalen Fortbildung der vorliegenden Erfindung kann vorgesehen sein, dass die Entflechtungskomponente dazu ausgelegt ist, die von der Leiterplatte in einem ersten bestimmten Flächenbereich abgegebenen mehreren elektromagnetischen Wellen zu entflechten und auf einen zweiten bestimmten Flächenbereich zu leiten, der in seiner Fläche größer als der erste bestimmte Flächenbereich ist.

Nach der Erfindung kann zudem vorgesehen sein, dass die Leiterplatte dazu ausgelegt ist, ein Taktsignal zu generieren und an die Entflechtungskomponente weiterzugeben, insbesondere über einen in der Entflechtungskomponente vorgesehenen Wellenleiter zum Weiterreichen an eine an die Entflechtungskomponete anbringbare Komponente.

Die Erfindung betrifft zudem ein Evaluationsboard, das eine modulare Antennenanordnung nach einem der vorstehend aufgeführten Aspekte aufweist.

Weitere Merkmale, Einzelheiten und Vorteile der Erfindung werden anhand der nachfolgenden Figurenbeschreibung ersichtlich. Dabei zeigen:
- Fig. 1:: eine schematische Schnittansicht einer erfindungsgemäßen modularen Antennenanordnung mit Leiterplatte und Entflechtungskomponente, und
- Fig. 2:: eine schematische Ansicht einer erfindungsgemäßen modularen Antennenanordnung mit Leiterplatte, Entflechtungskomponente und mehreren Sende-Empfangskomponenten,

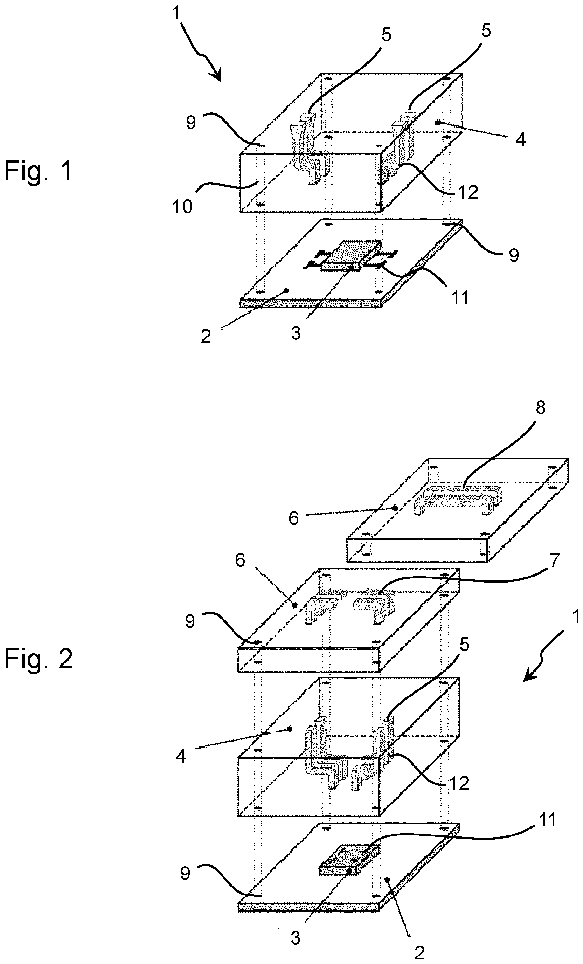

Fig. 1 zeigt eine Darstellung einer erfindungsgemäßen modularen Antennenanordnung 1, bei der die Leiterplatte 2 mit einem Chipsatz 3 versehen ist, der dazu ausgelegt ist, eine elektromagnetische Welle in einem hochfrequenten Bereich zu erzeugen bzw. eine solche Welle zu empfangen und zu verarbeiten.

Darüber, in einem von der Leiterplatte 2 abgehobenen Zustand, ist eine Entflechtungskomponente 4 dargestellt, die dazu dient, den auf der Leiterplatte 2 befindlichen Chipsatz 3 mit einem oder mehreren Antennenelementen zu verbinden. Nach der Erfindung kann auch vorgesehen sein, dass die mit dem Bezugszeichen 5 gekennzeichneten Übergabepunkte Antennenelemente sind, sodass die elektromagnetische Welle von der Entflechtungskomponente 4 abgestrahlt bzw. aufgenommen wird.

Die Entflechtungskomponente 4 leitet die elektromagnetische Welle typischerweise (aber nicht darauf beschränkt) unter der Verwendung von Hohlleitern 12, beispielsweise mit rechteckigem Querschnitt. Die Antenne(n) 5 können in die mindestens eine mit der Leiterplatte 2 zusammenwirkende Entflechtungskomponente 4 integriert sein, beispielsweise als strahlende Apertur eines offenen Hohlleiters 12, oder auf einer oder mehreren weiteren Komponenten (bspw. auf der nachfolgend näher bezeichneten Sende-Empfangskomponente 6) platziert sein.

Darüber hinaus ist zur korrekten Ausrichtung der Entflechtungskomponente 4 gegenüber der Leiterplatte 2 ein Ausrichtungsmittel 9 vorgesehen, dass bspw. mit den dargestellten Durchgangsbohrungen 10 und einem entsprechenden Passstift, der in die Durchgangsbohrung der Entflechtungskomponente 4 und der Leiterplatte 2 eingesteckt wird, umgesetzt ist. Setzt man also die Entflechtungskomponente 4 auf die Leiterplatte 2 auf und richtet die beiden Komponenten 2, 4 korrekt zueinander aus, so wird der auf die Leiterplatte 2 gerichtete Hohlleiter 12 genau so an der Leiterplatte 2 angeordnet sein, dass eine von der Leiterplatte 2 bzw. dem Chipsatz 3 abgestrahlte elektromagnetische Welle sich in einem jeweiligen dafür vorgesehenen Hohlleiter 12 ausbreitet.

In Figur 2 ist eine weitere Ausführungsform der vorliegenden Erfindung dargestellt, bei der die Entflechtung zum Teil oder vollständig in einer Komponente, der Entflechtungskomponente 4 ausgelagert ist, auf die eine Sende-Empfangskomponente 6 aufgebracht ist. Die Sende-Empfangskomponente 6 kann dabei ebenfalls eine Entflechtung enthalten, muss dies aber nicht.

Durch das weitere Vorsehen einer Sende-Empfangskomponente 6, können nun auf einfache Art und Weise unterschiedliche Typen von Antennen 7 untersucht werden, da es hierfür lediglich entsprechend ausgebildete Sende-Empfangskomponenten 6 bedarf, die dann einfach auf die Entflechtungskomponente der 4 aufzusetzen sind. Auch die Charakteristik bei einem Rückkoppeln von ausgesendeten elektromagnetischen Wellen kann mithilfe einer Sende-Empfangskomponente untersucht werden, die dann anstelle von abstrahlenden Antennen bspw. mindestens ein Koppelelement 8 aufweist, das zwei unterschiedliche Übergabepunkte 5 der Entflechtungskomponente 4 miteinander verbindet.

Die Entflechtungskomponente 4, wie auch die Sende-Empfangskomponente 6 kann beispielsweise aus Metall gefräst, durch Druckguss aus Metall oder Kunststoff gefertigt, oder 3D-gedruckt sein. Daneben sind auch dielektrische Strukturen möglich.

Da Position und der Typ der verwendeten Antennen 5, 7 entscheidende Systemeigenschaften wie beispielsweise den durch das System abgedeckten Raumbereich festlegen, kann das Gesamtsystem 1 durch die beschriebene Anordnung durch Austausch der Entflechtungskomponente 4 oder der Sende-Empfangskomponente 6 einfach an verschiedene Anwendungsszenarien adaptiert werden. Diese Tatsache ist vor allem bei der Evaluation von modularen MIMO-Antennenanordnungen, bspw. bei Kommunikations- und Radarsystemen, und den beinhalteten Chipsätzen in verschiedenen Anwendungsszenarien von großem Nutzen, da sie gegenüber dem Stand der Technik ausgetauscht werden können, ohne die darunter befindliche Leiterplatte 2 mit dem Chipsatz 3 modifizieren zu müssen.

Die Antennenanordnung 1 umfasst dabei einen oder mehrere Radar- oder Kommunikationschipsätze 3 sowie die weiteren für das System nötigen Bauteile, die die sich allesamt auf der Leiterplatte 2 befinden. Auf der Leiterplatte 2 können sogenannte Leiterplattenantennen 11 angeordnet sein, die sich im Gehäuse des Chipsatzes 3 befinden (wie in Fig. 2 dargestellt) oder als Platinenschnittstelle vorliegen (wie in Fig. 1 dargestellt). Auf die Leiterplatte 2 wird die Entflechtungskomponente 4 aufgebracht, die die elektromagnetische Welle von den im Chipsatz 3 integrierten Leiterplattenantennen 11 bzw. den Wellenleiterübergängen 11 zur abstrahlenden Apertur führt und diese dabei räumlich entzerrt. Als Wellenleiter kommen typischerweise Hohlleiter 12 zum Einsatz, wobei von der Erfindung jedoch auch andere Arten der Wellenleiter (beispielsweise dielektrische Wellenleiter) umfasst sind.

Ziel der Anordnung ist es, ein Gesamtsystem, welches einem auf elektromagnetischen Wellen beruhenden Ortungs- oder Kommunikationszweck dienen soll, in Bezug auf die verwendeten Antennentypen und -anordnungen modular und flexibel zu gestalten, sodass diese einfach gewechselt werden können.

Nach einer nicht in den Figuren dargestellten weiteren Ausführungsform können nach der Erfindung auf die Sende-Empfangskomponente 6 weitere Komponenten, wie beispielsweise eine Leiterplatte montiert werden, um zusätzliche Antennentypen zu ermöglichen.

Zu Evaluationszwecken kann die Sende-Empfangskomponente 6 mit auf Wellenleitern basierten Kopplungskomponente 8 versehen werden, bei der die von der Entflechtungskomponente 4 übernommene elektromagnetische Welle nicht abgestrahlt sondern zurückgekoppelt wird. Eine solche Komponente 8 ist in Fig. 2 neben einer Sende-Empfangskomponente 6, die mit Antennenelementen 7 versehen ist, dargestellt.

Die gesamte Antennenanordnung 1 ist modular aufgebaut und alle Teilkomponenten können, soweit sinnvoll, beliebig kombiniert werden. Folglich können auf eine Leiterplatte 2 durch Tausch der aufgesetzten Komponenten (Entflechtungskomponente 4 oder Sende-Empfangskomponente 6) verschiedene Antennentypen und -anordnungen realisiert werden. Die Sendeseite (Tx) und die Empfangsseite (Rx) kann unterschiedliche Entflechtungskomponenten beinhalten. Im Extremfall kann jede Antenne für sich eine eigene Komponente sein.

Mithilfe eines Ausrichtungsmittels 9, bspw. entsprechend zueinander fluchtende Bohrungen 10 mit darin eingesetzten Passstiften, können die Einzelkomponenten zueinander ausgerichtet und fixiert werden.

Nach einer weiteren von der Erfindung umfassten Ausführungsform kann es zur Kaskadierung mehrerer Systeme oder zur Evaluierung eines Gesamtsystems, welches aus kaskadierten Einzelsystemen besteht, von Vorteil sein, ein Taktsignal (z.B. Lokaloszillator) im Wellenleiter zu verteilen. Dieser mit dem Taktsignal beaufschlagte mindestens eine Wellenleiter kann beispielsweise in die Entflechtungskomponente integriert sein. Damit kann das modular aufgebaute System flexibel um weitere Chipsätze bzw. Sende- und/oder Empfangsantennen erweitert werden. Dies erfolgt dann bspw. derart, dass ein weiterer Chipsatz auf einer weiteren Leiterplatte mithilfe des Taktsignals synchronisiert werden kann. Es ist nach der Erfindung also möglich, mehrere Leiterplatten 2 mit einem jeweils darauf angeordneten Chipsatz 3 zusammenzuschließen, wobei das Taktsignal von einem taktgebenden Chipsatz in einen Wellenleiter der Entflechtungskomponente 4 eingespeist wird und der nicht-taktgebende Chipsatz den Taktimpuls über den Wellenleiter der Entflechtungskomponente 4 empfängt und sich hierauf synchronisiert. Dies ermöglicht eine deutlich komplexere Antennenanordnung, die dennoch auf einfache Art und Weise aufgebaut werden kann, da die einzelnen Komponenten keine elektrische Verbindung untereinander benötigen, sondern mithilfe von Wellenleitern, insbesondere Hohlwellenleitern kommunizieren.

Das Evaluieren komplexer Antennengeometrien wird dadurch signifikant vereinfacht.

### Bezugszeichenliste:

- 1: modulare Antennenanordnung
- 2: Leiterplatte
- 3: Chipsatz
- 4: Entflechtungskomponente
- 5: Übergabepunkt
- 6: Sende-Empfangskomponente
- 7: Antenne | Antennenapertur
- 8: Koppelelement
- 9: Ausrichtungsmittel
- 10: Durchgangsbohrung
- 11: Leiterplattenantenne
- 12: Hohlleiter | Wellenleiter

## Patentansprüche

1. Modulare Antennenanordnung (1), insbesondere modulare MIMO-Antennenanordnung, zum Evaluieren unterschiedlicher Antennenanordnungscharakteristika, umfassend:
eine Leiterplatte (2) mit einem Chipsatz (3), um eine hochfrequente elektromagnetische Welle zu senden und/oder zu empfangen,
mindestens eine Entflechtungskomponente (4) zum Aufsetzen auf die Leiterplatte (2), um die von der Leiterplatte (2) abgehende elektromagnetische Welle zu einem Übergabepunkt (5) der Entflechtungskomponente (4) und/oder die an einem Übergabepunkt (5) der Entflechtungskomponente (4) empfangene elektromagnetische Welle zu der Leiterplatte (2) zu leiten.

2. Modulare Antennenanordnung (1) nach dem vorhergehenden Anspruch 1, ferner umfassend eine Sende-Empfangskomponente (6) zum Aufsetzen auf die Entflechtungskomponente (4), um eine von der Leiterplatte (2) stammende elektromagnetische Welle von dem Übergabepunkt (5) der Entflechtungskomponente (4) aufzunehmen und über mindestens eine Antenne (7) abzustrahlen oder über ein Koppelelement (8) zurückzukoppeln, und/oder um eine von der Sende-Empfangskomponente (6) mittels mindestens einer Antenne (7) empfangene oder mittels mindestens einem Koppelelement (8) zurückgekoppelte elektromagnetische Welle an den Übergabepunkt (5) der Entflechtungskomponente (4) zum Weiterleiten an die Leiterplatte (2) zu übergeben.

3. Modulare Antennenanordnung (1) nach einem der vorhergehenden Ansprüche, wobei die Leiterplatte (2) und die Entflechtungskomponente (4) in einem aufgesetzten Zustand über ein Ausrichtungsmittel (9) verfügen, das eine vorgegebene Positionierung der Entflechtungskomponente (4) zu der Leiterplatte (2) definiert, vorzugsweise wobei das Ausrichtungsmittel (9) mindestens eine Durchgangsbohrung (10) in der Entflechtungskomponente (4) und der Leiterplatte (2) ist, die in einem aufgesetzten Zustand zueinander fluchten und durch welche ein Passstift einfügbar ist.

4. Modulare Antennenanordnung (1) nach einem der vorhergehenden Ansprüche, fortgebildet mit den Merkmalen des Anspruchs 2, wobei die Entflechtungskomponente (4) in einem aufgesetzten Zustand auf der Leiterplatte (2) zusammen mit der Leiterplatte (2) und/oder der Sende-Empfangskomponente (6) über ein Ausrichtungsmittel (9) verfügt, das eine vorgegebene Positionierung der Sende-Empfangskomponente (6) zu der Entflechtungskomponente (4) definiert, vorzugsweise wobei das Ausrichtungsmittel (9) mindestens eine Durchgangsbohrung (10) in der Entflechtungskomponente (4) und der Sende-Empfangskomponente (6) ist, die zueinander fluchten und durch welche ein Passstift einfügbar ist, bevorzugterweise derart, dass die Durchgangsbohrung (10) mit einer Durchgangsbohrung (10) in der Leiterplatte (2) fluchtet.

5. Modulare Antennenanordnung (1) nach einem der vorhergehenden Ansprüche, wobei mindestens eine Leiterplattenantenne (11) zum Senden und/oder Empfangen in einem Gehäuse des Chipsatzes (3) angeordnet ist, vorzugsweise als in den Chipsatz (3) integrierte Chipsatzantenne in Form eines Wellenleiterübergangs.

6. Modulare Antennenanordnung (1) nach einem der vorhergehenden Ansprüche, wobei mindestens eine Leiterplattenantenne zum Senden und/oder Empfangen neben einem Gehäuse des Chipsatzes (3) in der Leiterplatte (2) angeordnet ist, vorzugsweise als Platinenschnittstelle in Form eines Wellenleiterübergangs.

7. Modulare Antennenanordnung (1) nach einem der vorhergehenden Ansprüche, wobei der Chipsatz (3) dazu ausgelegt ist, eine Verarbeitung einer zu empfangenden und/oder einer zu sendenden elektromagnetischen Welle im Hochfrequenzbereich und im Basisbandbereich auszuführen.

8. Modulare Antennenanordnung (1) nach einem der vorhergehenden Ansprüche, wobei der Chipsatz (3) mindestens ein Radar- bzw. Kommunikationschipsatz ist, und/oder wobei eine Versorgungselektronik zum Betreiben des Chipsatzes (3) auf der Leiterplatte (2) angeordnet ist.

9. Modulare Antennenanordnung (1) nach einem der vorhergehenden Ansprüche, wobei die Entflechtungskomponente (4) und/oder die Sende-Empfangskomponente (6) mit Hilfe eines 3D-Druckverfahrens, eines Spritzgussverfahrens, eines Druckgussverfahrens und/oder eines Fräsverfahrens gefertigt ist/sind, vorzugsweise wobei ein Kunststoff das Grundmaterial für das Herstellverfahren bildet.

10. Modulare Antennenanordnung (1) nach einem der vorhergehenden Ansprüche, wobei die Entflechtungskomponente (4) und/oder die Sende-Empfangskomponente (6) metallisierte Bestandteile aufweist oder metallisiert ist.

11. Modulare Antennenanordnung (1) nach einem der vorhergehenden Ansprüche, fortgebildet mit den Merkmalen des Anspruchs 2, wobei die Sende-Empfangskomponente (6) dazu ausgelegt ist, eine von der Leiterplatte (2) stammende elektromagnetische Welle von der Entflechtungskomponente (4) aufzunehmen und an diese mittels eines Koppelelements (7) zurückzukoppeln, vorzugsweise durch das Verbinden von mehreren Übergabepunkten (5) der Entflechtungskomponente (4) mit einem Wellenleiter.

12. Modulare Antennenanordnung (1) nach einem der vorhergehenden Ansprüche, fortgebildet mit den Merkmalen des Anspruchs 2, wobei die Sende-Empfangskomponente (6) dazu ausgelegt ist, eine von der Leiterplatte (2) stammende elektromagnetische Welle von der Entflechtungskomponente (4) aufzunehmen und über eine Antennenapertur (7) abzustrahlen, vorzugsweise wobei die Sende-Empfangskomponente (6) eine Vielzahl von Antennenaperturen (7) aufweist, die nicht in einer gemeinsamen Ebene angeordnet sind, um eine 3D-Antenne zu bilden.

13. Modulare Antennenanordnung (1) nach einem der vorhergehenden Ansprüche, wobei die mindestens eine Entflechtungskomponente (4) zum Leiten der elektromagnetischen Welle mindestens einen Hohlleiter (12) aufweist, vorzugsweise wobei die Entflechtungskomponente (4) zum Leiten mehrerer von der Leiterplatte (2) stammender elektromagnetischer Wellen mehrere Hohlleiter (12) aufweist, deren Leitungskanäle in der Entflechtungskomponente (4) nicht miteinander verbunden sind.

14. Modulare Antennenanordnung (1) nach einem der vorhergehenden Ansprüche, wobei die Entflechtungskomponente (4) dazu ausgelegt ist, die von der Leiterplatte (2) in einem ersten bestimmten Flächenbereich abgegebenen mehreren elektromagnetischen Wellen zu entflechten und auf einen zweiten bestimmten Flächenbereich zu leiten, der in seiner Fläche größer als der erste bestimmte Flächenbereich ist.

15. Modulare Antennenanordnung (1) nach einem der vorhergehenden Ansprüche, wobei die Leiterplatte (2) dazu ausgelegt ist, ein Taktsignal zu generieren und an die Entflechtungskomponente (4) weiterzugeben, insbesondere über einen in der Entflechtungskomponente (4) vorgesehenen Wellenleiter (12) zum Weiterreichen an eine an die Entflechtungskomponente (4) anbringbare Komponente.
